Europäisches Patentamt

**European Patent Office**

Office européen des brevets

(19)

(11) Numéro de publication: **0 034 957**
**B1**

(12) **FASCICULE DE BREVET EUROPEEN**

(45) Date de publication du fascicule du brevet:
**12.06.85**

(51) Int. Cl.⁴: **H 04 B 9/00**

(21) Numéro de dépôt: **81400111.1**

(22) Date de dépôt: **27.01.81**

(54) **Dispositif de régulation automatique de puissance de sortie d'un module émetteur pour système de transmission sur fibre optique.**

(30) Priorité: **22.02.80 FR 8003983**

(43) Date de publication de la demande:
**02.09.81 Bulletin 81/35**

(45) Mention de la délivrance du brevet:
**12.06.85 Bulletin 85/24**

(84) Etats contractants désignés:
**BE CH DE GB IT LI NL**

(56) Documents cités:
**DE - A - 2 737 345**
**DE - A - 2 737 345**

**RCA TECHNICAL NOTE, no. 1005, 9 avril 1975 Princeton, US J.P. WITTKE: "Stabilization of CW injection lasers", pages 1-3**
**NTC'78 NATIONAL CONFERENCE RECORD 1978, NATIONAL TELECOMMUNICATIONS CONFERENCE, vol. 1, Birmingham, Alabama, 3-6 décembre 1978, IEEE New York, US J.A. BARLOW: "A 30-channel 2.048 MBIT optical system", pages 5.2.1 - 5.2.5**

(73) Titulaire: **LIGNES TELEGRAPHIQUES ET TELEPHONIQUES L.T.T., 1, rue Charles Bourseul, F-78702 Conflans-Ste-Honorine (FR)**

(72) Inventeur: **Breton, Jean-Paul, THOMSON-CSF SCPI 173, bld Haussmann, F-75360 Paris Cedex 08 (FR)**
Inventeur: **Maciaszek, Adalbert, THOMSON-CSF SCPI 173, bld Haussmann, F-75360 Paris Cedex 08 (FR)**

(74) Mandataire: **Weinmiller, Jürgen et al, Zeppelinstrasse 63, D-8000 München 80 (DE)**

## Description

La présente invention se rapporte d'une manière générale aux systèmes de transmission sur fibre optique et concerne plus particulièrement un dispositif de régulation automatique de puissance de sortie du module émetteur pour système simplifié de transmission pour liaison monofibre.

Un système de transmission sur fibre optique est constitué d'un module émetteur, d'un module récepteur et d'une fibre agencée entre ces modules. Le module émetteur comporte une embase émettrice constituée d'une diode laser, d'une photodiode de contrôle et d'une optique de couplage laser-fibre insérée dans une fiche de connecteur pour le raccordement de ladite embase au câble à fibre optique, et une électronique de commande assurant entre autres une régulation de la puissance optique émise. Le module récepteur comporte une embase détectrice constituée d'un photodétecteur, tel qu'une photodiode à avalanche, et d'une optique de couplage photodiode-fibre insérée dans une fiche de connecteur pour le raccordement de l'embase au câble à fibre optique, et une électronique de commande assurant entre autres une régulation automatique de gain de la photodiode à avalanche. Pour une description détaillée du module émetteur, on se reportera par exemple à l'article publié dans la revue: «THE BELL SYSTEM TECHNICAL JOURNAL», Volume 57, n° 6, Juillet-août 1978, page 1823, intitulé: «GaAlAs Laser Transmitter for Lightwave Transmission Systems».

On sait que dans un système de transmission sur fibre optique, le courant de la diode laser utilisée dans le module émetteur, en présence d'informations numériques à transmettre, résulte de la superposition de son courant continu de polarisation et de son courant de modulation; les impulsions lumineuses sont ainsi émises dans la fibre à la puissance nominale optique de la diode laser.

Pour un module émetteur à diode laser, on connaît déjà un circuit permettant de réguler le courant continu de la diode laser en fonction de la température, connecté entre un capteur de température et la diode laser, et comportant des moyens de compensation des variations de la puissance de sortie dues au vieillissement de la diode laser, comme cela est décrit dans l'article publié dans «RCA Technical Notes», n° 1005, 9 avril 1975, pages 1–3, intitulé: «Stabilization of cw injection lasers».

On connaît également pour un module émetteur à diode laser, et d'après la demande de brevet allemand n° 2 923 683, un circuit permettant de réguler le courant de modulation de la diode laser en fonction des informations à transmettre en compensant un écart du rapport durée/écart des informations.

La présente invention a pour but d'une part de réguler automatiquement la puissance nominale optique émise par la diode laser, en assurant simultanément une régulation du courant continu et une régulation du courant de modulation de la diode laser, d'autre part de prévenir l'utilisateur de la présence d'un mauvais fonctionnement d'un circuit du module émetteur, et en particulier du vieillissement de la diode laser, et également de supprimer le courant de modulation dans la diode laser si la fréquence des informations à transmettre est élevée.

A cet effet, l'invention a pour objet un dispositif de régulation automatique de puissance de sortie dans un module émetteur de système de transmission d'informations utilisant une fibre optique et comportant un ensemble dans lequel sont disposés une diode laser, des moyens de prélèvement d'une partie de la puissance optique émise par la diode laser et de conversion en puissance électrique, et un capteur de température, et un premier circuit de régulation du courant continu de la diode laser en fonction de la température, connecté entre le capteur de température et la diode laser, caractérisé en ce que le dispositif comporte un second circuit de régulation du courant de modulation de la diode laser, connecté entre les moyens de conversion et la diode laser, et comportant:

– un premier générateur de courant variable en fonction de la puissance de la diode laser, et commandé par un premier circuit ayant une borne d'entrée des informations à transmettre, une première borne de sortie reliée à l'entrée du générateur et une seconde borne de sortie reliée à la première borne d'entrée d'une porte logique ET;

– des moyens formant interrupteur connectés entre le générateur de courant et la diode laser, et commandés par un second circuit connecté entre la borne de sortie de la porte logique ET et les moyens formant interrupteur, la borne d'entrée du premier circuit de commande reliée au second circuit de commande; et

– un circuit de limitation sensible à la fréquence des informations à transmettre ayant une première borne d'entrée reliée à la borne d'entrée du premier circuit de commande, une seconde borne d'entrée reliée à la seconde borne de sortie du premier circuit de commande, et une borne de sortie reliée à la seconde borne d'entrée de la porte logique ET.

Selon une autre caractéristique de l'invention, le dispositif de régulation automatique de puissance comporte de plus un circuit de déclenchement d'alarme à seuil connecté en parallèle sur la sortie des moyens de conversion et comportant des moyens à retard connectés entre la seconde borne de sortie du premier circuit de commande du premier générateur de courant et l'une des bornes d'entrée d'une porte logique, l'autre borne d'entrée de la porte étant reliée à la sortie d'un moyen comparateur de tension dont l'entrée est reliée à la sortie des moyens de conversion, et la borne de sortie de la porte étant reliée à un dispositif d'alarme.

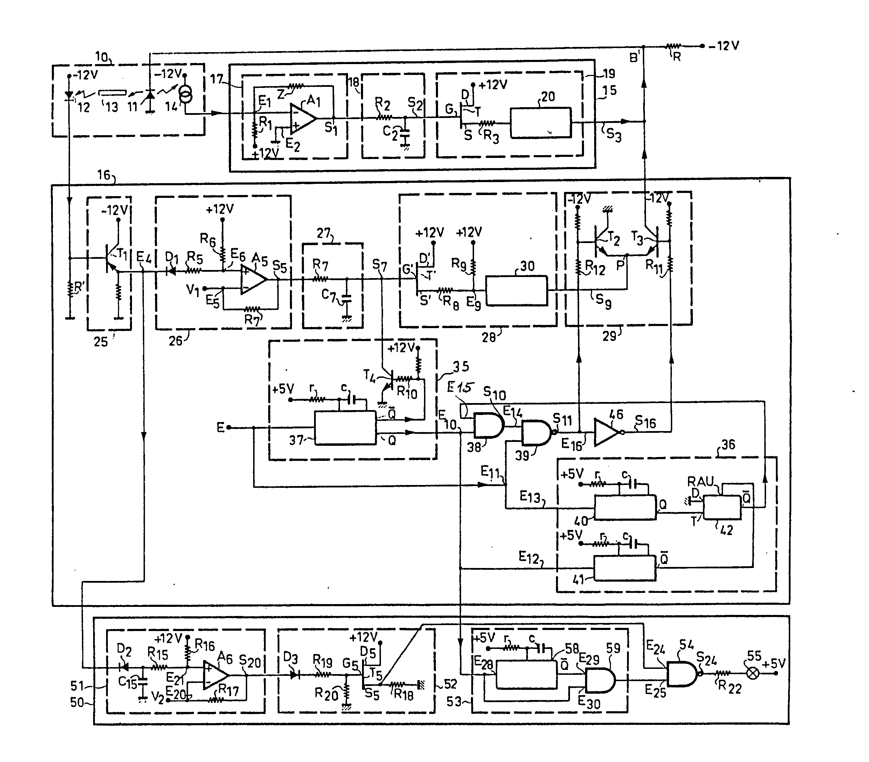

D'autres caractéristiques et avantages de l'invention apparaîtront mieux dans la description détaillée qui suit et se réfère à l'unique dessin annexé, donné uniquement à titre d'exemple et qui est un diagramme partiellement sous forme électrique du module émetteur comportant le dispositif de régulation automatique de puissance selon l'invention.

Suivant un exemple de réalisation et en se reportant au dessin annexé, le module émetteur d'un système de transmission utilisant une seule fibre optique comprend un ensemble 10 réalisé sous forme d'un boîtier dans lequel sont disposés une diode laser 11 dont la puissance optique émise est injectée dans la fibre (non représentée), des moyens de prélèvement d'une partie de la puissance optique émise par la diode laser et de conversion en puissance électrique constitués par exemple par une photodiode 12 alimentée en − 12 volts, une fibre de couplage 13 entre la diode laser et la photodiode 12, et une sonde ou capteur de la température du boîtier 10 réalisé sous forme d'un générateur de courant 14 alimenté en − 12 volts. En outre, on a représenté en R la résistance de polarisation de la diode laser 11, ayant une valeur fixe prédéterminée et étant connectée en série entre la diode laser et une tension d'alimentation de − 12 volts.

Selon l'invention, le dispositif de régulation automatique de puissance de sortie de la diode laser 11 dans le module émetteur comporte un premier circuit 15 de régulation du courant continu de polarisation de la diode laser connecté entre la sonde de température 14 et la diode laser 11, et un second circuit 16 de régulation du courant de modulation de la diode laser connecté entre la photodiode 12 et la diode laser 11.

Comme on le voit bien sur la figure, le premier circuit 15 de régulation du courant de polarisation de la diode laser 11 comprend en série un convertisseur courant-tension 17, un filtre passe-bas 18 et un générateur 19 de courant variable en fonction de la température du boîtier 10 et à constante de temps élevée vis-à-vis de la cadence de transmission.

Plus précisément, le convertisseur courant-tension 17 est constitué d'un amplificateur opérationnel $A_1$ monté en transimpédance dont une entrée $E_1$ est connectée à la sonde de température 14 et dont l'autre entrée $E_2$ est reliée à la masse. D'autre part, on a représenté en Z l'impédance de contre-réaction connectée entre la sortie $S_1$ et l'entrée $E_1$ de l'amplificateur opérationnel $A_1$, une résistance $R_1$ étant connectée entre l'entrée $E_1$ et une tension d'alimentation de + 12 volts. L'amplificateur opérationnel $A_1$ fournit en sortie $S_1$ une tension fonction du courant d'entrée engendré par le générateur de courant 14.

En outre, le filtre passe-bas 18 est constitué d'une seule cellule $R_2$ $C_2$, la résistance $R_2$ étant connectée à la sortie $S_1$ de l'amplificateur opérationnel $A_1$ et le condensateur $C_2$ étant relié à la masse. Enfin, le générateur de courant 19 est constitué d'un transistor à effet de champ T dont la grille G est connectée à la sortie $S_2$ du filtre passe-bas 18, dont le drain D est connecté à une tension d'alimentation de + 12 volts, et dont la source S est connectée, par l'intermédiaire d'une résistance $R_3$, à un amplificateur de courant 20 de structure classique. La sortie $S_3$ de l'amplificateur de courant 20 est connectée en B à la diode laser 11, c'est-à-dire en parallèle sur la résistance de polarisation R.

D'autre part, le second circuit 16 de régulation du courant de modulation comprend en série un circuit adaptateur d'impédance 25, un circuit comparateur de tension 26, un filtre passe-bas 27, un générateur 28 de courant variable en fonction de la puissance de la diode laser 11, et un circuit formant interrupteur du type hacheur 29 commandé par les informations numériques à transmettre. On a représenté en R' la résistance de contre-réaction de la photodiode 12.

Plus précisément, le circuit adaptateur d'impédance 25 est constitué d'un transistor $T_1$ monté en émetteur suiveur, le collecteur de ce transistor étant connecté à une alimentation de − 12 volts. Le circuit comparateur de tension 26, dont l'entrée $R_4$ est connectée à l'émetteur du transistor $T_1$, comprend un amplificateur opérationnel $A_5$ dont une entrée $E_5$ est reliée à une source de tension de référence $V_1$ correspondant à la puissance nominale optique émise par la diode laser 11. De plus, une diode $D_1$, dont la cathode est reliée à l'émetteur du transistor $T_1$, et une résistance $R_5$ sont connectées en série entre la borne $E_4$ et l'autre entrée $E_6$ de l'amplificateur opérationnel $A_5$. Une résistance $R_6$ est connectée entre l'entrée $E_6$ de l'amplificateur $A_5$ et une alimentation de + 12 volts, et une résistance de contre-réaction $R_7$ est connectée entre la sortie $S_5$ et l'entrée $E_5$ de l'amplificateur $A_5$.

En outre, le filtre passe-bas 27 est constitué d'une seule cellule $R_7$ $C_7$, la résistance $R_7$ étant connectée à la sortie $S_5$ de l'amplificateur opérationnel $A_5$ et le condensateur $C_7$ étant relié à la masse.

Le générateur de courant 28 est constitué d'un transistor à effet de champ T' dont la grille G' est connectée à la sortie $S_7$ du filtre passe-bas 27, dont le drain D' est connecté à une alimentation de + 12 volts, et dont la source S' est connectée, par l'intermédiaire d'une résistance $R_8$, à l'entrée $E_9$ d'un amplificateur de courant 30 de structure classique. On a représenté en $R_9$ une résistance connectée entre l'entrée $E_9$ de l'amplificateur de courant 30 et une alimentation de + 12 volts.

D'autre part, le circuit du type hacheur 29 est constitué de deux transistors $T_2$ et $T_3$ alimentés en − 12 volts avec leurs émetteurs respectifs reliés entre eux, la sortie $S_9$ de l'amplificateur de courant 30 étant connectée à une borne commune P des émetteurs. En outre, le collecteur du transistor $T_2$ est directement relié à la masse, tandis que le collecteur du transistor $T_3$ est connecté en B à la diode laser 11. Comme on l'expliquera par la suite, les deux transistors $T_2$ et $T_3$ fonctionnent en alternance et à bas niveau.

Avantageusement, ce circuit hacheur 29 peut être réalisé sous forme d'un circuit hybride, ce qui en abaisse notablement le coût de réalisation.

Le circuit 16 de régulation du courant de modulation de la diode laser comprend également un circuit 35 de commande du générateur de courant 28 et un circuit 36 de limitation sensible à la fréquence des informations à transmettre.

Plus précisément, le circuit 35 de commande du générateur de courant 28 comporte un monostable 37 alimenté +5 volts (dont on a représenté la résistance r et le condensateur c définissant ainsi le temps pendant lequel le monostable est dans son état stable), ayant deux sorties complémentaires Q et $\overline{Q}$ et une borne E d'entrée des informations numériques à transmettre. La sortie $\overline{Q}$ du monostable 37 est reliée, par l'intermédiaire d'une résistance $R_{10}$, à la base d'un transistor $T_4$ alimenté en +12 volts et monté en émetteur commun, le collecteur du transistor $T_4$ étant connecté à la sortie $S_7$ du filtre passe-bas 27. D'autre part, la sortie Q du monostable 37 est reliée à l'une des bornes d'entrée $E_{10}$ d'une porte logique ET 38, tandis que l'entrée E du monostable 37 est reliée à l'une des bornes d'entrée $E_{11}$ d'une porte logique ET-NON 39.

Le circuit 36 de limitation sensible à la fréquence des informations à transmettre est constitué d'un premier monostable 40 (avec sa résistance r et son condensateur c), d'un second monostable 41 dont l'entrée $E_{12}$ est connectée en parallèle sur l'entrée $E_{10}$ de la porte ET 38, et un circuit bistable 42 ayant une entrée des données D reliée à la masse, une entrée horloge T reliée à la sortie Q du monostable 40 et une entrée de remise à un (RAU) reliée à la sortie $\overline{Q}$ du monostable 41. L'entrée $E_{13}$ du monostable 40 est connectée en parallèle sur l'entrée $E_{11}$ de la porte logique ET-NON 39, l'autre borne d'entrée $E_{14}$ de cette dernière reliée à la borne de sortie $S_{10}$ de la porte logique ET 38.

La sortie $\overline{Q}$ du circuit bistable 42 est reliée à l'autre borne d'entrée $E_{15}$ de la porte logique ET 38, tandis que la borne de sortie $S_{11}$ de la porte logique ET-NON 39 est reliée à l'entrée $E_{16}$ d'un inverseur 46 dont la sortie $S_{16}$ est reliée, par l'intermédiaire d'une résistance $R_{11}$, à la base du transistor $T_3$. De plus, la base du transistor $T_2$ est reliée, par l'intermédiaire d'une résistance $R_{12}$, à la sortie $S_{11}$ de la porte logique ET-NON 39. La porte logique ET-NON 39 et l'inverseur 46 constituent donc un circuit de commande du moyen formant interrupteur 29.

Selon l'invention, le module émetteur du système de transmission sur fibre optique qui vient d'être décrit comporte de plus un circuit 50 de déclenchement d'alarme à seuil permettant de prévenir l'utilisateur principalement du vieillissement de la diode laser 11.

Comme on le voit bien sur la figure, ce circuit 50 de déclenchement d'alarme comprend un circuit comparateur de tension 51, un circuit 52 de mise en forme du signal engendré par le circuit comparateur 51, un circuit à retard 53, une porte logique ET-NON 54, et un dispositif d'alarme, tel que par exemple un voyant 55.

Plus précisément, le circuit comparateur de tension 51 est constitué d'un amplificateur opérationnel $A_6$ dont une entrée $E_{20}$ est reliée à une source de tension de référence $V_2$. De plus, une diode $D_2$ et un circuit intégrateur comprenant un condensateur $C_{15}$ et une résistance $R_{15}$ sont connectés en série entre la borne d'entrée $E_4$ du circuit comparateur de tension 26 et l'autre entrée $E_{21}$ de l'amplificateur opérationnel $A_6$. Une résistance $R_{16}$ est connectée entre l'entrée $E_{21}$ de l'amplificateur $A_6$ et une alimentation de +12 volts, et une résistance de contre-réaction $R_{17}$ est connectée entre la sortie $S_{20}$ et l'entrée $E_{20}$ de l'amplificateur $A_6$.

Le circuit de mise en forme 52 est constitué d'un transistor à effet de champ $T_5$ dont le drain $D_5$ est connecté à une alimentation de +12 volts, dont la source $S_5$ est connectée à une résistance $R_{18}$ reliée à la masse, et dont la grille $G_5$ est connectée à un réseau comportant une diode $D_3$ reliée à la sortie $S_{20}$ de l'amplificateur $A_6$, une résistance $R_{19}$ en série, et une résistance $R_{20}$ reliée à la masse.

La porte logique ET-NON 54 a une première borne d'entrée $E_{24}$ connectée à la source $S_5$ du transistor à effet de champ $T_5$, une seconde borne d'entrée $E_{25}$ connectée à la sortie du circuit à retard 53, et une borne de sortie $S_{24}$ à laquelle sont connectés en série une résistance $R_{22}$ et le voyant 55 alimenté en +5 volts.

En outre, le circuit à retard 53 comporte un monostable 58 (avec sa résistance r et son condensateur c) dont l'entrée $E_{28}$ est reliée à la borne d'entrée $E_{10}$ de la porte logique ET 38, et dont la sortie $\overline{Q}$ est reliée à une première borne d'entrée $E_{29}$ d'une porte logique ET 59. L'autre borne d'entrée $E_{30}$ de cette porte logique ET 59 est reliée à l'entrée $E_{28}$ du monostable 58.

On expliquera dans ce qui suit le fonctionnement du dispositif de régulation automatique de puissance de la diode laser et du circuit de déclenchement d'alarme selon l'invention qui viennent d'être décrits précédemment.

On rappellera tout d'abord qu'en présence d'informations numériques à transmettre, le courant de la diode laser 11 résulte de la superposition de son courant de polarisation et de son courant de modulation, de sorte que l'amplitude des impulsions lumineuses transmises dans la fibre optique dépend de la puissance optique émise par la diode laser. Comme on souhaite transmettre les impulsions lumineuses à la puissance maximale de sortie de la diode laser, il s'avère nécessaire de stabiliser cette puissance maximale optique; cette stabilisation est obtenue en effectuant une régulation du courant de modulation de la diode laser. D'autre part, lorsque la température du boîtier renfermant la diode laser varie, la caractéristique de transfert de la diode laser (puissance de sortie en fonction du courant) est modifiée, de sorte qu'une régulation du courant continu de la diode laser en fonction de la température permet une détection sur le vieillissement de la diode laser, identique dans la gamme des températures d'utilisation.

On expliquera maintenant, à l'aide de la figure, la régulation du courant continu de la diode laser en fonction de la température du boîtier renfermant la diode laser.

Lorsque la température du boîtier varie, le courant constant engendré par la résistance de polarisation R de la diode laser 11 peut n'être plus suffisant pour permettre une polarisation convenable de la diode laser, étant donné que la caractéristique de transfert de la diode se modifie en fonction de la température. Dans ces conditions, le courant de polarisation recherché est obtenu en ajoutant au courant dans la résistance R, un courant continu de régulation en fonction de la température produit par le circuit de régulation 15 de la manière suivante.

Lors d'une variation de la température du boîtier, le générateur de courant 14 délivre un courant fonction de la température qui est converti en une tension par l'amplificateur monté en transimpédance 17. Le signal de sortie est ensuite présenté, après passage dans le filtre passe-bas 18, au générateur de courant 19 qui fournit en sa sortie $S_3$ un courant continu de régulation. Ainsi, la somme du courant dans la résistance R et du courant de régulation obtenu donne le courant de polarisation recherché par la diode laser 11.

La régulation du courant de modulation de la diode laser, destinée à stabiliser la puissance nominale optique émise par la diode laser, s'effectue de la façon suivante.

Aux bornes de la résistance de contre-réaction R', apparaît le signal électrique engendré par la photodiode 12 dont le courant est fonction de la puissance optique émise par la diode laser 11. Après passage dans le circuit adaptateur d'impédance 25, le signal est redressé par la diode $D_1$, puis son niveau est comparé par l'amplificateur $A_5$ à un niveau de référence $V_1$ correspondant à la puissance nominale de sortie de la diode laser 11. Le signal délivré à la sortie $S_5$ de l'amplificateur $A_5$ est présenté, après passage dans le filtre passe-bas 27, au générateur de courant variable 28 commandé par le circuit 35.

Supposons que l'entrée E du circuit 35 de commande du courant de modulation ne reçoive aucune information numérique à transmettre, et qu'on utilise une logique dite positive, c'est-à-dire qu'à une tension nulle correspond un niveau "0" et qu'à une tension positive ou négative correspond un niveau "1". Dans ce cas d'absence d'informations, les sorties Q et $\overline{Q}$ du monostable 37 sont respectivement aux niveaux "0" et "1". Ainsi, le transistor $T_4$ est saturé et la tension à la sortie $S_7$ du filtre passe-bas 27 est nulle. Dès lors, le courant dans la résistance $R_8$ est nul, et le courant présenté à l'entrée de l'amplificateur de courant 30 correspond au courant dans la résistance $R_9$. D'autre part, la sortie Q du monostable 37 étant au niveau "0", la sortie $S_{10}$ de la porte logique ET 38 est au niveau "0", la sortie $S_{11}$ de la porte logique ET-NON 39 est au niveau "1" et la sortie $S_{16}$ de l'inverseur 46 est au niveau "0". Dans ces conditions, le transistor $T_2$ conduit tandis que le transistor $T_3$ est bloqué, ce qui ne donne lieu à aucun courant en sortie du circuit hacheur 29.

Supposons maintenant que l'entrée E du circuit 35 de commande du courant de modulation reçoive les informations numériques à transmettre. Dans ce cas, les sorties Q et $\overline{Q}$ du monostable 37 sont respectivement aux niveaux "1" et "0".

Ainsi, le transistor $T_4$ est bloqué et la tension à la sortie $S_7$ du filtre passe-bas 27 varie suivant la régulation à puissance nominale à assurer déterminée en sortie de l'amplificateur $A_5$. Dès lors, le générateur de courant 28 fournit en sa sortie $S_9$ un courant destiné à assurer la régulation du courant de modulation de la diode laser. D'autre part, la sortie Q du monostable 37 étant au niveau "1" et en supposant que l'entrée $E_{15}$ de la porte logique ET 38 est aussi au niveau "1" obtenu en sortie de la bascule 42, la sortie $S_{10}$ de cette porte ET est au niveau "1". Dès lors, la porte logique ET-NON 39 recevant sur son entrée $E_{14}$ un niveau "1" et sur son autre entrée $E_{11}$ les informations numériques à transmettre, sa sortie $S_{11}$ fournit ces mêmes informations numériques, mais en opposition de phase. De plus, en sortie $S_{16}$ de l'inverseur 46, on obtient les informations numériques en opposition de phase avec celles présentes en sortie $S_{11}$ de la porte logique ET-NON 39. De cette manière, les transistors $T_2$ et $T_3$ fonctionnent alternativement, de sorte qu'on obtient en sortie du transistor $T_3$ une régulation du courant de modulation de la diode laser. D'autre part, on supprime le courant de modulation dans la diode laser lorsque la fréquence des informations à transmettre est supérieure à une fréquence maximale prédéterminée. Ceci est réalisé par le circuit 36 de limitation en fréquence des informations numériques à transmettre. Ainsi, lorsque la fréquence des informations à transmettre est inférieure à la fréquence maximale prédéterminée, la sortie Q du monostable 40 fournit des impulsions et la sortie $\overline{Q}$ du circuit bistable 42 est au niveau "1". Dans ces conditions, la sortie $S_{10}$ de la porte logique ET 38 est au niveau "1", de sorte que la régulation du courant de modulation de la diode laser peut avoir lieu. D'autre part, lorsque la fréquence des informations à transmettre est supérieure à la fréquence maximale, la sortie Q du monostable 40 et au niveau "1" et la sortie $\overline{Q}$ du circuit bistable 42 est au niveau "0" du fait de l'impulsion «négative» fournie par la sortie $\overline{Q}$ du monostable 41. Dans ces conditions, la sortie $S_{10}$ de la porte ET 38 est au niveau "0", la sortie $S_{11}$ de la porte logique ET-NON 39 est au niveau "1", la sortie $S_{16}$ de l'inverseur 46 est au niveau "0", de sorte qu'on a un courant de modulation nul en sortie du circuit hacheur 29. Ainsi, on empêche la diode laser de se détériorer. Cela se produirait aux fréquences élevées à la suite d'une saturation du circuit adaptateur 25. Pour fonctionner à des fréquences plus élevées, on modifie ce circuit adaptateur 25 et on change la constante de temps donnée par la résistance r et le condensateur c associés au monostable 40.

On expliquera maintenant le fonctionnement du dispositif de déclenchement d'alarme 50 selon l'invention.

A la sortie $E_4$ du circuit adaptateur d'impédance 25, le signal est redressé par la diode $D_2$, puis son niveau est comparé par l'amplificateur $A_6$ à un niveau de référence $V_2$ correspondant à un multiple k inférieur à 1 de la puissance nominale de sortie de la diode laser 11. Le voyant d'alarme 55 s'allumera donc lorsque la puissance optique émise par la diode laser sera inférieure à la puissance optique de référence égale à k. Puissance nominale, prévenant ainsi l'utilisateur du vieillissement de la diode laser.

Cependant, lors de la mise en route des informations numériques à transmettre, la puissance optique émise par la diode laser ne se stabilise pas immédiatement à sa puissance nominale, de sorte que le voyant 55 s'allume. Le circuit à retard 53 prévu dans le dispositif de déclenchement d'alarme permet précisément d'éviter une telle indication intempestive de l'alarme. En effet, lors de la mise en route des informations, la sortie Q du monostable 37 est au niveau "1", et l'entrée $E_{30}$ de la porte logique ET 59 est également au niveau "1". En outre, la sortie $\overline{Q}$ du monostable 58 est au niveau "0" pendant le temps T = rc, de sorte que la sortie de la porte logique ET 59 est à un niveau "0" pendant le temps T, et est à un niveau "1" après le temps T. Or, au moment de la mise en route des informations, on a une tension positive de +5 volts (niveau d'alarme "1") en sortie du transistor à effet de champ $T_5$ pendant un temps T' sensiblement égal à T/3 qui correspond au temps nécessaire requis pour la stabilisation à la puissance nominale de la diode laser. Dans ces conditions, pendant le temps T, on a un niveau "1", c'est-à-dire une tension de +5 volts, en sortie $S_{24}$ de la porte logique ET-NON 54. Dès lors, aucun courant ne passe dans la résistance $R_{22}$, de sorte que le voyant 55 ne s'allume pas.

Après avoir obtenu la stabilisation à la puissance nominale de la diode laser, l'entrée $E_{25}$ de la porte ET-NON 54 est à un niveau "1". En présence d'une tension positive de +5 volts (niveau d'alarme "1") en sortie du transistor à effet de champ $T_5$, c'est-à-dire lorsque la puissance optique émise par la diode laser est inférieure à la puissance optique de référence, la sortie $S_{24}$ de la porte logique ET-NON 54 est au niveau "0", correspondant à une tension nulle. Dès lors, le voyant d'alarme 55 s'allume, indiquant par conséquent à l'utilisateur qu'il faut remplacer prochainement la diode laser. Par contre, si on a une tension nulle (niveau d'alarme "0") en sortie du transistor à effet de champ $T_5$, c'est-à-dire lorsque la puissance optique émise par la diode laser est supérieure à la puissance optique de référence, la sortie $S_{24}$ de la porte logique ET-NON 54 est au niveau "1", correspondant à une tension de +5 volts, de sorte que le voyant d'alarme 55 ne s'allume pas.

**Revendications**

1. Dispositif de régulation automatique de puissance de sortie dans un module émetteur de système de transmission d'informations utilisant une fibre optique et comportant un ensemble (10) dans lequel sont disposés une diode laser (11), des moyens de prélèvement (12) d'une partie de la puissance optique émise par la diode laser et de conversion en puissance électrique, et un capteur (14) de température, et un premier circuit (15) de régulation du courant continu de la diode laser en fonction de la température, connecté entre le capteur de température (14) et la diode laser (11), caractérisé en ce que le dispositif comporte un second circuit (16) de régulation du courant de modulation de la diode laser, connecté entre les moyens de conversion (12) et la diode laser (11), et comportant:
   - un premier générateur (28) de courant variable en fonction de la puissance de la diode laser (11), et commandé par un premier circuit (35) de commande ayant une borne (E) d'entrée des informations à transmettre, une première borne (S7) de sortie reliée à l'entrée du générateur et une seconde borne de sortie reliée à la première borne (E10) d'entrée d'une porte logique ET(38);
   - des moyens formant interrupteur (29) connectés entre le générateur de courant (28) et la diode laser (11), et commandés par un second circuit (39, 46) de commande connecté entre la borne (S10) de sortie de la porte logique ET(38) et les moyens formant interrupteur, la borne (E) d'entrée du premier circuit de commande (35) étant reliée au second circuit de commande; et
   - un circuit (36) de limitation sensible à la fréquence des informations à transmettre ayant une première borne (E13) d'entrée reliée à la borne (E) d'entrée du premier circuit de commande (35), une seconde borne (E12) d'entrée reliée à la seconde borne (E10) de sortie du premier circuit de commande (35), et une borne de sortie reliée à la seconde borne (E15) d'entrée de la porte logique ET(38).

2. Dispositif selon la revendication 1, caractérisé en ce que le circuit (36) de limitation sensible à la fréquence comporte:
   - un premier monostable (40) dont l'entrée est connectée à la première borne d'entrée dudit circuit de limitation;
   - un second monostable (41) dont l'entrée est connectée à la seconde borne d'entrée dudit circuit de limitation; et
   - un circuit bistable (42) connecté entre les sorties respectives des premier et second monostables, et ayant une borne de sortie reliée à la seconde borne d'entrée de la porte logique ET(38).

3. Dispositif selon la revendication 1, caractérisé en ce que le second circuit (16) de régulation du courant de modulation de la diode laser comporte de plus en série:
   - des moyens comparateur de tension (26) dont l'entrée est reliée aux moyens de conversion (12); et
   - un premier filtre passe-bas (27) dont la sortie est connectée au générateur de courant (28).

4. Dispositif selon la revendication 1, caractérisé en ce que le premier circuit (15) de régulation du courant continu de la diode laser comporte en série:
   - un amplificateur opérationnel ($A_1$) monté en transimpédance dont l'entrée est connectée au capteur de température (14);
   - un second filtre passe-bas (18); et

– un second générateur (19) de courant variable en fonction de la température de l'ensemble (10), et à constante de temps élevée vis-à-vis de la cadence de transmission, la sortie du second générateur de courant étant connectée à la diode laser (11).

5. Dispositif selon l'une des revendications précédentes, caractérisé en ce qu'il comporte également un circuit (50) de déclenchement d'alarme à seuil connecté en parallèle sur la sortie des moyens de conversion (2) et comportant des moyens à retard (53) connectés entre la seconde borne de sortie du premier circuit de commande du premier générateur de courant (28) et l'une des bornes d'entrée d'une porte logique (54), l'autre borne d'entrée de la porte étant reliée à la sortie d'un moyen comparateur de tension (51) dont l'entrée est reliée à la sortie des moyens de conversion, et la borne de sortie de la porte (54) étant reliée à un dispositif d'alarme (55).

## Claims

1. A device for the automatic output power regulation in an emitter module of an information transmission system using an optical fibre and comprising a unit (10) in which are disposed a laser diode (10), means (12) for sampling a fraction of the optical power emitted by the laser diode and for converting it into electrical power, and a temperature probe (14), and comprising a first circuit (15) for the regulation of the direct current of the laser diode as a function of the temperature, this circuit being inserted between the temperature probe (14) and the laser diode (11), characterized in that the device comprises a second circuit (16) for the regulation of the modulation current of the laser diode, connected between the conversion means (12) and the laser diode (11) and comprising:

– a first generator (28) of a current which varies as a function of the power of the laser diode (11), and which is controlled by a first control circuit (35) having an input terminal (E) for the informations to be transmitted, a first output terminal ($S_7$) connected to the input of the generator, and a second output terminal connected to the first input terminal ($E_{10}$) of a logic AND gate (38),
– interruptor means (29) connected between the current generator (28) and the laser diode (11), and controlled by a second control circuit (39, 46) which is connected between the output terminal ($S_{10}$) of the logic AND gate (38) and the interruptor means, the input terminal (E) of the first control circuit (35) being connected to the second control circuit, and
– a limitation circuit (36) sensible to the frequency of the informations to be transmitted, said circuit having a first input terminal ($E_{13}$) connected to the input terminal (E) of the first control circuit (35), a second input terminal ($E_{12}$) connected to the second output terminal ($E_{10}$) of the first control circuit (35), and an output terminal connected to the second input terminal ($E_{15}$) of the logic AND gate (38).

2. A device according to claim 1, characterized in that the limitation circuit (36) which is sensible to the frequency comprises:
– a first monostable flip-flop (40), the input of which is connected to the first input terminal of said limitation circuit,
– a second monostable flip-flop (41), the input of which is connected to the second input terminal of said limitation circuit, and
– a bistable circuit (32) connected between the output of the first and second monostable flip-flops respectively and having an output terminal connected to the second input terminal of the logic AND gate (38).

3. A device according to claim 1, characterized in that the second circuit (16) for the regulation of the modulation current of the laser diode further comprises in series:
– voltage comparison means (26), the input of which is connected to the conversion means (12), and
– a first low-pass filter (27), the output of which is connected to the current generator (28).

4. A device according to claim 1, characterized in that the first circuit (15) for regulating the direct current of the laser diode comprises in series:
– an operational amplifier ($A_1$), mounted in transimpedance, the input of which is connected to the temperature probe (14),
– a second low-pass filter (18), and
– a second generator (19) of a current which varies as a function of the temperature of the unit (10), this generator providing a high time constant compared with the transmission rate, the output of the second current generator being connected to the laser diode (11).

5. A device according to one of the preceding claims, characterized in that it further comprises a threshold circuit (50) for releasing an alarm, connected in parallel to the output of the conversion means (12) and comprising delay means (53) connected between the second output terminal of the first control circuit of the first current generator (28) and one of the input terminals of a logic gate (54), the other input terminal of the gate being connected to the output of a voltage comparing means (51), the input of which is connected to the output of the conversion means, and the output terminal of the gate (54) being connected to an alarm device (55).

## Patentansprüche

1. Vorrichtung zur automatischen Regelung der Ausgangsleistung in einem Sendermodul eines Informations-Übertragungssystems, das eine Glasfaser verwendet, wobei die Vorrichtung eine Einheit (10), in der eine Laserdiode (11), Mittel zur Entnahme (12) eines Teils der von der Laserdiode ausgesandten optischen Leistung und zur Umwandlung in elektrische Leistung, und eine Temperatur-Messsonde (14) enthalten sind, und einen ersten Kreis (15) zur Gleichstromregelung der Laserdiode in Abhängigkeit von der Temperatur aufweist, der zwischen die Temperatur-Messsonde (14) und die Laserdiode (11) geschaltet ist, dadurch gekennzeichnet, dass die Vorrichtung einen zweiten Kreis (16) zur Regelung des Modulationsstroms der Laserdiode aufweist, der zwischen die Umwandlungsmittel (12) und die Laserdiode (11) geschaltet ist und der aufweist:

– einen ersten Generator (28) für variablen Strom in Abhängigkeit von der Leistung der Laserdiode (11), und gesteuert von einem ersten Steuerkreis (35) mit einer Eingangsklemme (E) für die zu übertragenden Informationen, einer ersten Ausgangsklemme ($S_7$), die mit dem Eingang des Generators verbunden ist, und einer zweiten Ausgangsklemme, die mit der ersten Eingangsklemme ($E_{10}$) eines logischen UND-Tors (38) verbunden ist,

– Mittel, die einen Unterbrecher (29) bilden und zwischen den Stromgenerator (28) und die Laserdiode (11) eingefügt sind und von einem zweiten Steuerkreis (39, 46) gesteuert werden, der zwischen die Ausgangsklemme ($S_{10}$) des logischen UND-Tors (38) und die einen Unterbrecher bildenden Mittel geschaltet ist, wobei die Eingangsklemme (E) des ersten Steuerkreises (35) mit dem zweiten Steuerkreis verbunden ist, und

– einen Begrenzungskreis (36), der für die Frequenz der zu übertragenden Informationen sensibel ist und von dem eine erste Eingangsklemme ($E_{13}$) mit der Eingangsklemme (E) des ersten Steuerkreises (35), eine zweite Eingangsklemme ($E_{12}$) mit der zweiten Ausgangsklemme ($E_{10}$) des ersten Steuerkreises (35) und eine Ausgangsklemme mit der zweiten Eingangsklemme ($E_{15}$) des logischen UND-Tors (38) verbunden ist.

2. Vorrichtung nach Anspruch 1, dadurch gekennzeichnet, dass der frequenzsensible Begrenzungskreis (36)

– eine erste monostabile Kippstufe (40), deren Eingang mit der ersten Eingangsklemme des Begrenzungskreises verbunden ist,

– eine zweite monostabile Kippstufe (41), deren Eingang mit der zweiten Eingangsklemme des Begrenzungskreises verbunden ist, und

– einen bistabilen Kreis (42) aufweist, der zwischen die Ausgänge der ersten bzw. zweiten monostabilen Kippstufe geschaltet ist und von dem eine Ausgangsklemme mit der zweiten Eingangsklemme des logischen UND-Tors (38) verbunden ist.

3. Vorrichtung nach Anspruch 1, dadurch gekennzeichnet, dass der zweite Kreis (16) zur Regelung des Modulationsstroms der Laserdiode ausserdem in Reihe aufweist:

– Spannungsvergleichermittel (26), deren Eingang mit den Umwandlungsmitteln (12) verbunden ist, und

– ein erstes Tiefpassfilter (27), dessen Ausgang mit dem Stromgenerator (28) verbunden ist.

4. Vorrichtung nach Anspruch 1, dadurch gekennzeichnet, dass der erste Kreis (15) zur Regelung des Gleichstroms der Laserdiode in Reihe aufweist:

– einen Operationsverstärker ($A_1$), der in Transimpedanz geschaltet ist und dessen Eingang mit der Temperatur-Messsonde (14) verbunden ist,

– ein zweites Tiefpassfilter (18), und

– einen zweiten Generator (19), dessen Strom in Abhängigkeit von der Temperatur der Einheit (10) variiert und der eine hohe Zeitkonstante gegenüber der Übertragungskadenz besitzt, wobei der Ausgang des zweiten Stromgenerators mit der Laserdiode (11) verbunden ist.

5. Vorrichtung nach einem der vorhergehenden Ansprüche, dadurch gekennzeichnet, dass sie ausserdem einen Schwellenkreis (50) zur Alarmauslösung aufweist, der parallel an den Ausgang der Umwandlungsmittel (12) angeschlossen ist und der Verzögerungsmittel (53) aufweist, die zwischen der zweiten Ausgangsklemme des ersten Steuerkreises für den ersten Stromgenerator (28) und einer der Eingangsklemmen eines logischen Tors (54) eingefügt sind, während die andere Eingangsklemme des Tors mit dem Ausgang eines Spannungsvergleichermittels (51), dessen Eingang an den Ausgang der Umwandlungsmittel angeschlossen ist, und die Ausgangsklemme des Tors (54) mit einer Alarmvorrichtung (55) verbunden ist.